# EUROPEAN PATENT APPLICATION

(11) **EP 4 838 712 A1**
(43) Date of publication of application: **11.11.2026**
(21) Application number: 24915638.1
(22) Date of filing: 04.01.2024
(51) Int. Cl.: H01R 12/71

(54) **ELECTRONIC DEVICE**

(71) Applicant: Nintendo Co., Ltd., Kyoto-shi, Kyoto 601-8501 (JP)
(72) Inventor: KANKI, Yosuke, Kyoto-shi, Kyoto 601-8501 (JP); KATO, Koichi, Kyoto-shi, Kyoto 601-8501 (JP); HIROSE, Shinji, Kyoto-shi, Kyoto 601-8501 (JP)
(74) Representative: Bardehle Pagenberg Partnerschaft mbB Patentanwälte Rechtsanwälte
(86) International application number: PCT/JP2024/000027
(87) International publication number: WO 2025/146714

(57) **Abstract**

Electronic device can reduce likelihood that connector is disconnected from board or housing or is damaged when connected to external connector. Electronic device includes housing, board, connector, and antenna. Board is located in housing. Connector is mounted on mount surface of board. Connector is configured to be connected to external connector. Antenna at least partially overlaps connector as viewed in thickness direction of board perpendicular to mount surface of board. Antenna includes antenna pattern that is conductive. Antenna and connector are integrally fastened to at least one of housing or board.

## Description

### TECHNICAL FIELD

The present disclosure relates to an electronic device including a connector connectable to an external connector.

### BACKGROUND ART

Patent Literature 1 describes a connector mounted on a board included in an electronic device, such as a smartphone. The connector is connectable to an external connector that is to be connected to the electronic device. The connector is thus exposed outside the electronic device.

### PRIOR ART DOCUMENTS

### PATENT LITERATURE

Patent Literature 1: JP-A-2017-076472

### SUMMARY OF THE INVENTION

### PROBLEMS TO BE SOLVED BY THE INVENTION

To connect the connector in the electronic device to an external connector, one of the connector in the electronic device or the external connector is placed into the other.

During or after such placement, one of the external connector or the connector in the electronic device can be twisted relative to the other. In other words, one of the external connector or the electronic device connector can be distorted relative to the other. This may disconnect the connector in the electronic device from the board or the housing or can break the connector.

One or more aspects of the present disclosure are directed to an electronic device that reduces the likelihood that the connector is disconnected from the board or the housing or is damaged when connected to an external connector.

### SOLUTIONS TO THE PROBLEMS

In response to the above, an electronic device according to one or more aspects of the present disclosure may have, for example, one of the structures (1) to (14) below.
(1) An electronic device according to an aspect of the present disclosure includes a housing, a board, a connector, and an antenna. The board is located in the housing. The connector is mounted on a mount surface of the board. The connector is connectable to an external connector. The antenna at least partially overlaps the connector as viewed in a thickness direction of the board perpendicular to the mount surface of the board. The antenna includes an antenna pattern that is conductive. The antenna and the connector are integrally fastened to at least one of the housing or the board.

According to the structure (1), the connector is integrally fastened to at least one of the housing or the board together with the antenna while overlapping the antenna in the thickness direction. The antenna thus increases the strength of fastening the connector to at least one of the housing or the board. The antenna thus reduces misalignment between the connectors when one of the external connector or the connector in the electronic device is twisted relative to the other. This reduces the likelihood that the connector is disconnected from the board or the housing or is damaged.

According to the structure (1), the connector and the antenna overlap each other as viewed in the thickness direction. The electronic device thus has more unused space on the mount surface of the board than an electronic device with the connector and the antenna not overlapping each other as viewed in the thickness direction. This allows more components to be mounted on the mount surface.

According to the structure (1), the connector and the antenna overlap each other as viewed in the thickness direction. The antenna is thus located adjacent to the connector. The connector is connectable to an external connector. More specifically, the connector is located nearer the outside of the electronic device. Thus, the antenna is also located nearer the outside of the electronic device. This improves the radiation characteristics of the antenna compared with an electronic device including the antenna located farther from the outside of the electronic device.

(2)
In the structure (1), an electronic device according to another aspect of the present disclosure may further include a heat dissipator and a fan. The heat dissipator includes a metal. The heat dissipator is adjacent to the connector in the housing. The fan has an inlet and an outlet. The heat dissipator may include an internal space, a facing surface, a first side surface, and a second side surface. The internal space is open outside through a first clearance and a second clearance. The facing surface faces the housing in the thickness direction. The first side surface extends in the thickness direction from the facing surface and has the first clearance. The second side surface extends in the thickness direction from the facing surface and has the second clearance. The inlet of the fan may face the housing in the thickness direction. The outlet of the fan may face the first clearance of the heat dissipator. The antenna may include a first portion overlapping the connector as viewed in the thickness direction, and a second portion located in a clearance between the facing surface of the heat dissipator and the housing. The second portion at least partially blocks a flow channel extending from the second clearance of the heat dissipator to the inlet of the fan through the clearance between the facing surface of the heat dissipator and the housing.

When a gas is discharged through the outlet of the fan, the gas enters the internal space of the heat dissipator through the first clearance and is cooled in the internal space. The cooled gas is discharged out of the heat dissipator through the second clearance. The gas discharged out of the heat dissipator through the second clearance is expected to be discharged out of the electronic device. However, part of the gas discharged out of the heat dissipator through the second clearance can enter the inlet of the fan through a flow channel instead of being discharged out of the electronic device. In this case, air cooled by the heat dissipator re-enters the heat dissipator through the fan. This can deteriorate the efficiency of cooling the gas through the heat dissipator.

According to the structure (2), the second portion of the antenna is located in the clearance between the facing surface of the heat dissipator and the housing. More specifically, the second portion of the antenna at least partially blocks the flow channel. This reduces entry of gas discharged from the heat dissipator into the fan through the flow channel. The heat dissipator thus has less deterioration in the efficiency of cooling the gas.

According to the structure (2), the antenna is located in the clearance between the facing surface of the heat dissipator and the housing. This eliminates an additional component for filling the clearance between the facing surface of the heat dissipator and the housing, reducing the number of components included in the electronic device.

According to the structure (2), the antenna is located in the clearance between the facing surface of the heat dissipator and the housing. The heat dissipator is thus less likely to move toward the housing.

(3)
In the structure (2), the antenna pattern may be located in the first portion and may not be located in the second portion.

The heat dissipator includes a metal. Thus, for an antenna pattern of the antenna adjacent to the heat dissipator, the radiation characteristics of the antenna pattern can be deteriorated by the heat dissipator. According to the structure (3), the antenna pattern is not located in the second portion adjacent to the heat dissipator, and is located in the first portion farther from the heat dissipator than the second portion. The antenna pattern thus has less deterioration in the radiation characteristics caused by the heat dissipator. The antenna may include a portion without the antenna pattern, or more specifically, the second portion that is not associated with the radiation characteristics. The second portion can block the clearance between the facing surface of the heat dissipator and the housing.

(4)
In the structure (2) or (3), an electronic device according to another aspect of the present disclosure may further include an internal frame. The internal frame is in the housing. The internal frame includes a metal and faces the board in the thickness direction. A clearance may be defined between the antenna and the internal frame as viewed in the thickness direction. The electronic device according to the aspect of the present disclosure may further include a filler that is insulating. The filler fills the clearance between the antenna and the internal frame as viewed in the thickness direction.

The internal frame includes a metal. Thus, for an antenna pattern of the antenna adjacent to the internal frame, the radiation characteristics of the antenna pattern can be deteriorated by the internal frame. According to the structure (4), the clearance is defined between the antenna and the internal frame as viewed in the thickness direction. The antenna pattern is thus located away from the internal frame. The antenna pattern thus has less deterioration in the radiation characteristics caused by the internal frame.

For the electronic device having a clearance between the antenna and the internal frame, heat generated in a heat-generating component such as an integrated circuit mounted on the board can spread over the wide area in the housing. According to the structure (4), the clearance between the antenna and the internal frame is filled with the insulating filler. The filler thus reduces heat dissipation from the heat-generating component through the clearance. The filler is insulating, and thus the antenna pattern has less deterioration in the radiation characteristics caused by the filler.

(5)
In any one of the structures (1) to (4), an electronic device according to another aspect of the present disclosure may further include an audio input-output component adjacent to the connector in the housing. The audio input-output component is configured to receive an audio terminal. The audio input-output component and the connector may be integrally fastened to at least one of the housing or the board.

According to the structure (5), the connector is integrally fastened together with the audio input-output component. The audio input-output component thus increases the strength of fastening the connector to at least one of the housing or the board. The audio input-output component thus reduces misalignment between the connectors under a force applied from the external connector to the connector in the electronic device in a direction in which the connector in the electronic device is misaligned relative to the board or the housing. This reduces the likelihood that the connector is disconnected from the board or the housing or is damaged.

According to the structure (5), the audio input-output component is integrally fastened together with the connector. The connector thus increases the strength of fastening the audio input-output component to at least one of the housing or the board. This reduces the likelihood that the audio input-output component is damaged under a force applied from the audio terminal to the audio input-output component in a direction different from the direction in which the audio terminal is placed.

(6)
In the structure (5), an electronic device according to another aspect of the present disclosure may further include a first fastener integrally fastening the antenna and the connector to at least one of the housing or the board, and a second fastener integrally fastening the antenna and the audio input-output component to at least one of the housing or the board.

According to the structure (6), the antenna and the first fastener increase the fastening strength of the connector, and the antenna and the second fastener increase the fastening strength of the audio input-output component.

(7)
In the structure (6), the connector may include a connection terminal configured to be connected to an external connector. The audio input-output component may include an insertion port to receive an audio terminal. The connection terminal and the insertion port may be located between the first fastener and the second fastener.

According to the structure (7), the connection terminal and the insertion port are located between the first fastener and the second fastener. The first fastener and the second fastener thus increase the fastening strength of the connector and the audio input-output component.

(8)
In the structure (6) or (7), an electronic device according to another aspect of the present disclosure may further include a third fastener between the first fastener and the second fastener. The third fastener integrally fastens the connector and the audio input-output component to at least one of the housing or the board.

According to the structure (8), the connector and the antenna are integrally fastened by the first fastener, and the audio input-output component and the antenna are integrally fastened by the second fastener. In addition, the connector and the audio input-output component are further integrally fastened by the third fastener. This increases the fastening strength of the connector and the audio input-output component.

When a third fastener integrally fastens the antenna to the connector and the audio input-output component, the area for the antenna pattern on the antenna can be reduced by the third fastener. According to the structure (8), the third fastener is not used to fasten the antenna. The area for the antenna pattern on the antenna is thus less likely to be reduced by the third fastener. The area for the antenna pattern is thus less likely to be smaller. This avoids deterioration in the radiation characteristics of the antenna pattern.

(9)
In any one of the structures (1) to (8), an electronic device according to another aspect of the present disclosure may further include a filter mounted on the board. The board may include a first ground pattern electrically connected to the connector, and a second ground pattern electrically connected to the first ground pattern through the filter and electrically connected to the antenna.

According to the structure (9), the first ground pattern and the second ground pattern are electrically connected to each other through the filter. The filter can remove at least part of noise propagating between the first ground pattern and the second ground pattern.

According to the structure (9), the connector is electrically connected to the first ground pattern, and the antenna is electrically connected to the second ground pattern. As described above, the filter removes at least part of noise propagating between the first ground pattern and the second ground pattern. This reduces noise propagation between the connector and the antenna.

(10)
In the structure (9), the second ground pattern may have a larger area than the first ground pattern.

According to the structure (10), the second ground pattern that is electrically connected to the antenna has a larger area, allowing the antenna to have stable radiation characteristics.

(11)
In the structure (9) or (10), a current flowing through the connector may have a lower frequency band than a current flowing through the antenna.

The characteristics of an electronic component through which a current with a high frequency band flows can easily change when the electronic component is electrically connected to a ground pattern having a smaller area. The ground pattern to be electrically connected to an electronic component through which a current with a high frequency band flows may thus have an area as large as possible. In contrast, the characteristics of an electronic component through which a current with a low frequency band flows are less likely to change when the electronic component is electrically connected to a ground pattern having a smaller area.

According to the structure (11), the second ground pattern to be electrically connected to the antenna through which a current with a high frequency band flows has a larger area. The characteristics of the antenna, which can change depending on the area size of the second ground pattern, are thus less likely to change.

(12)
In any one of the structures (9) to (11), the housing may include a metal frame. The second ground pattern may be electrically connected to the metal frame. The connector may be fastened to the metal frame indirectly to prevent electrical connection to the metal frame.

According to the structure (12), the second ground pattern is electrically connected to the metal frame. This allows the area with the same potential as the second ground pattern to be larger.

According to the structure (12), the connector is fastened to the metal frame of the housing without being electrically connected to the second ground pattern.

(13)
In the structure (12), the board may include a substrate that is insulating, and the first ground pattern and the second ground pattern located on a surface of the substrate or inside the substrate, or on the surface of the substrate and inside the substrate. The connector may be fastened to the metal frame with the substrate located between the connector and the metal frame. The connector may be out of contact with the second ground pattern.

According to the structure (13), the connector is fastened to the substrate without being electrically connected to the second ground pattern.

(14)
In the structure (13), the antenna may include a base that is insulating, and the antenna pattern on a surface of the base. The connector may be held between the base and the substrate. The connector may be in contact with the base and the substrate and may be out of contact with the antenna pattern and the second ground pattern.

According to the structure (14), the connector is fastened to the substrate and the antenna without being electrically connected to the second ground pattern and the antenna pattern.

### EFFECTS OF THE INVENTION

The electronic device according to any one of the above aspects of the present disclosure reduces the likelihood that the connector is disconnected from the board or the housing or is damaged when connected to an external connector.

### BRIEF DESCRIPTION OF THE DRAWINGS

Fig. 1 is a schematic perspective view of an electronic device and a cradle according to an embodiment of the present disclosure.
Fig. 2 is a schematic front view of the electronic device according to the embodiment of the present disclosure.
Fig. 3 is a schematic plan view of the electronic device according to the embodiment of the present disclosure.
Fig. 4 is a cross-sectional view taken along line IV-IV in Fig. 3.
Fig. 5 is a cross-sectional view corresponding to Fig. 4 from which an internal frame, an antenna, and a filler are removed.
Fig. 6 is an enlarged view of a part enclosed by the dot-dash line in Fig. 4.
Fig. 7 is a cross-sectional view taken along line VII-VII in Fig. 6.
Fig. 8 is a cross-sectional view taken along line VIII-VIII in Fig. 6.
Fig. 9 is an enlarged view of a portion enclosed by the dot-dash line in Fig. 8.
Fig. 10 is a cross-sectional view taken along line X-X in Fig. 6.
Fig. 11 is a cross-sectional view taken along line XI-XI in Fig. 6.

### DETAILED DESCRIPTION

Embodiments of the present disclosure will be described below with reference to the drawings. The present disclosure is not limited to these embodiments. In the drawings, like reference numerals denote substantially the same components.

For ease of explanation, directional terms such as up, down, and height are used herein to describe the components in typical use. These terms are not intended to limit the use or other situations of an electronic device according to one or more embodiments of the present disclosure.

### (Embodiments)

The structure of an electronic device according to an embodiment of the present disclosure will be described. The electronic device according to one or more embodiments of the present disclosure is, for example, a gaming device, a smartphone, or a personal computer. In the example described below, the electronic device is, for example, a gaming device.

In the present embodiment, the electronic device is a portable device that is placed on a mount surface, such as a floor or a desktop, or held by a user when used. The electronic device may have features other than gaming. For example, the electronic device may be a personal computer (PC) that can execute games, such as a portable gaming PC. The gaming process may be performed on a console or a cloud server separate from the electronic device, rather than being performed on the electronic device. In this case, for example, the electronic device displays, on its display, images or videos generated through the process performed on the separate console or cloud server.

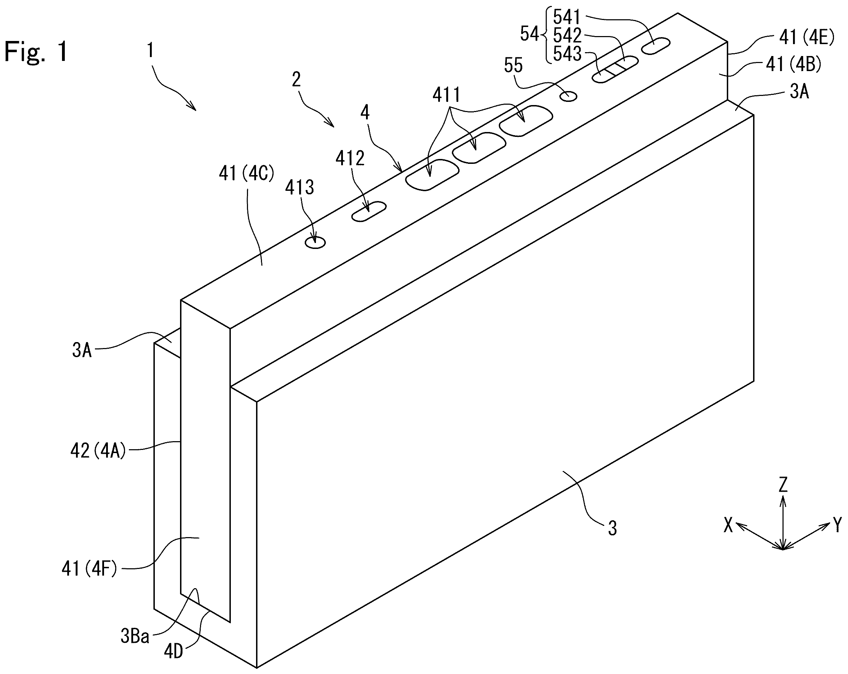

Fig. 1 is a schematic perspective view of an electronic device and a cradle according to an embodiment of the present disclosure.

As shown in Fig. 1, an electronic device support system 1 includes an electronic device 2 and a cradle 3. The cradle 3 can support the electronic device 2. In Fig. 1, the cradle 3 supports the electronic device 2.

For ease of explanation, the electronic device 2 has a depth direction referred to as the X-direction, a width direction as the Y-direction, and a height direction as the Z-direction herein and in the drawings. The X-direction, the Y-direction, and the Z-direction are perpendicular to one another. The cradle 3 has the X-direction, the Y-direction, and the Z-direction defined with the electronic device 2 attached to the cradle 3 (the state shown in Fig. 1).

The cradle 3 has a groove 3B recessed from an upper surface 3A in the Z-direction. The groove 3B extends in the Y-direction. The electronic device 2 is placed into the groove 3B to be attached to the cradle 3. A connector (not shown) on a second side surface 4D of the electronic device 2 is then connected to a connector (not shown) on a bottom surface 3Ba of the groove 3B in the cradle 3. This electrically couples the electronic device 2 and the cradle 3.

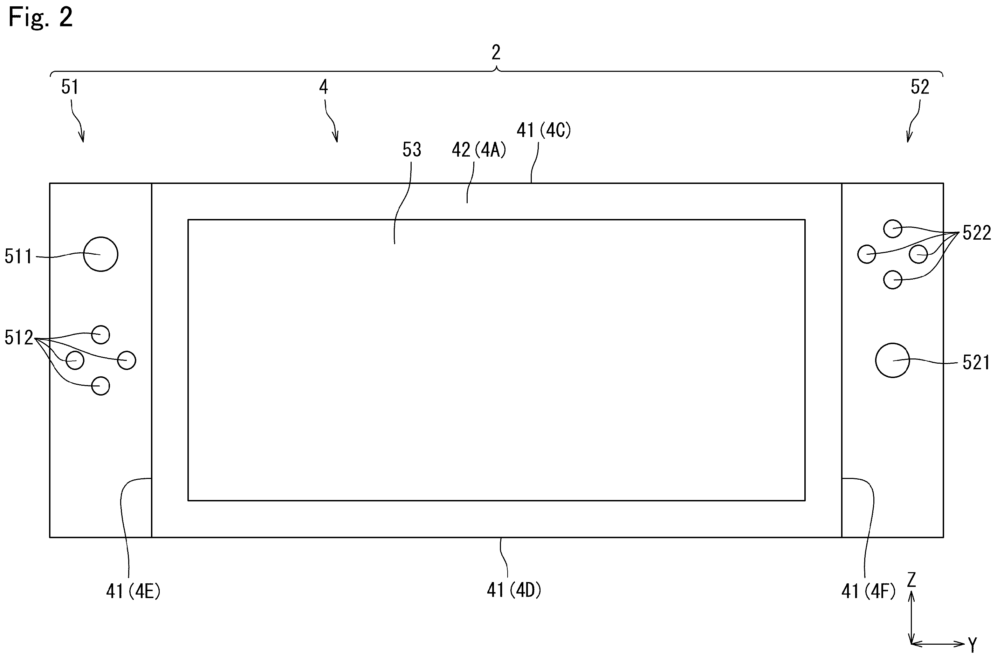

Fig. 2 is a schematic front view of the electronic device according to the embodiment of the present disclosure.

As shown in Fig. 2, the electronic device 2 includes a housing 4 and two controllers 51 and 52.

The two controllers 51 and 52 shown in Fig. 2 are used to operate the electronic device 2. The two controllers 51 and 52 may be connected to a board 61 with a wire, or may remotely operate the electronic device 2 through a network such as the Internet. In this case, multiple users at different locations can play the game performed on the electronic device 2.

Each of the two controllers 51 and 52 includes, for example, a stick and operation buttons used for operations. In the present embodiment, the controller 51 includes a stick 511 and operation buttons 512, and the controller 52 includes a stick 521 and operation buttons 522. The two controllers 51 and 52 are attachable to and detachable from the housing 4. The two controllers 51 and 52 may be attached to or detached from the housing 4 in any known manner, such as fitting, sliding, or with magnets. The electronic device 2 may include a single controller or may not include a controller.

As shown in Figs. 1 and 2, the housing 4 is a substantially rectangular prism with an internal space. As described later, the internal space accommodates various components. The housing 4 may have a shape other than a substantially rectangular prism.

The housing 4 has a front surface 4A, a back surface 4B, and four side surfaces (a first side surface 4C, a second side surface 4D, a third side surface 4E, and a fourth side surface 4F) extending in the X-direction from the back surface 4B to the front surface 4A. The internal space of the housing 4 is surrounded by the front surface 4A, the back surface 4B, and the four side surfaces.

The front surface 4A and the back surface 4B are spaced from each other in the X-direction perpendicular to the front surface 4A. The front surface 4A and the back surface 4B face away from each other.

The first side surface 4C and the second side surface 4D are spaced from each other in the Z-direction. The first side surface 4C and the second side surface 4D face away from each other. The third side surface 4E and the fourth side surface 4F are spaced from each other in the Y-direction. The third side surface 4E and the fourth side surface 4F face away from each other.

The housing 4 includes a first housing 41 (lower housing) and a second housing 42 (upper housing). The first housing 41 has the back surface 4B and the four side surfaces (the first side surface 4C, the second side surface 4D, the third side surface 4E, and the fourth side surface 4F). The second housing 42 has the front surface 4A. The second housing 42 is connected to the first housing 41 in any known manner, such as fitting or screwing. The first housing 41 and the second housing 42 are combined to form the housing 4. In the schematic figures, the first housing 41 and the second housing 42 are integral with each other.

The housing 4 may be an integrally molded single member or may be a combination of three or more members.

In the present embodiment, the first housing 41 includes a resin, and the second housing 42 includes a metal (specifically, magnesium). The second housing 42 is an example of a metal frame. The first housing 41 may include a material other than a resin, such as a metal. The second housing 42 may include a metal other than magnesium, or a material other than a metal, such as a resin. The first housing 41 and the second housing 42 may include a metal, a resin, or a combination of a metal and a resin.

A display 53 is located on the front surface 4A of the housing 4. The electronic device 2 may allow, for example, images and videos to be displayed on an external display such as a television. In this case, for example, the electronic device 2 includes a universal serial bus (USB, registered trade mark) terminal. The electronic device 2 is connected to the external display with a USB cable.

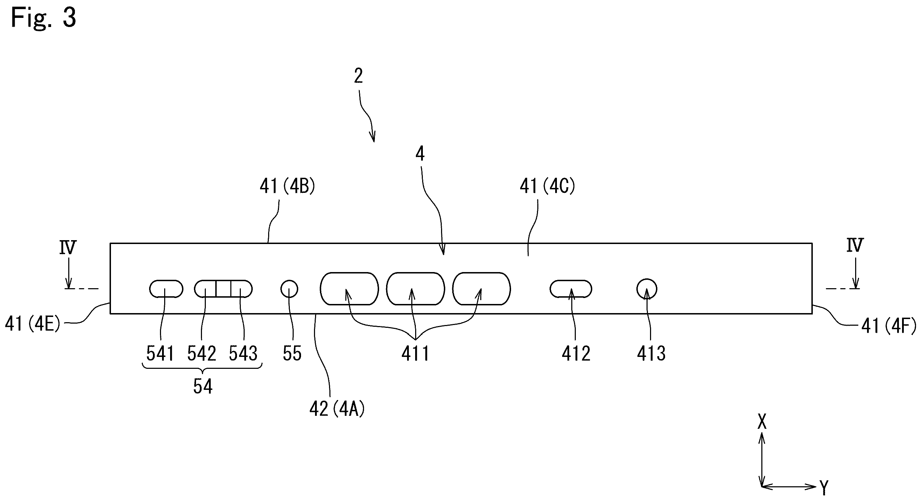

Fig. 3 is a schematic plan view of the electronic device according to the embodiment of the present disclosure.

As shown in Fig. 3, the housing 4 has multiple openings in the first side surface 4C. For example, the multiple openings include air vents 411, a first connector opening 412, a second connector opening 413, openings for allowing an external device to access operation buttons 54, and an opening for allowing an optical sensor 55 to receive light. The first connector opening 412 receives, for example, a terminal (a connection terminal 71A in the present embodiment) on a charging cable or a terminal for inputting and outputting data such as images or videos. The second connector opening 413 receives an audio input-output component 8. The multiple openings connect the outside and the inside of the housing 4. Each opening may not be located in the first side surface 4C, and may be located in another surface (the front surface 4A, the back surface 4B, the second side surface 4D, the third side surface 4E, or the fourth side surface 4F). The electronic device 2 may not include one or more of the multiple openings.

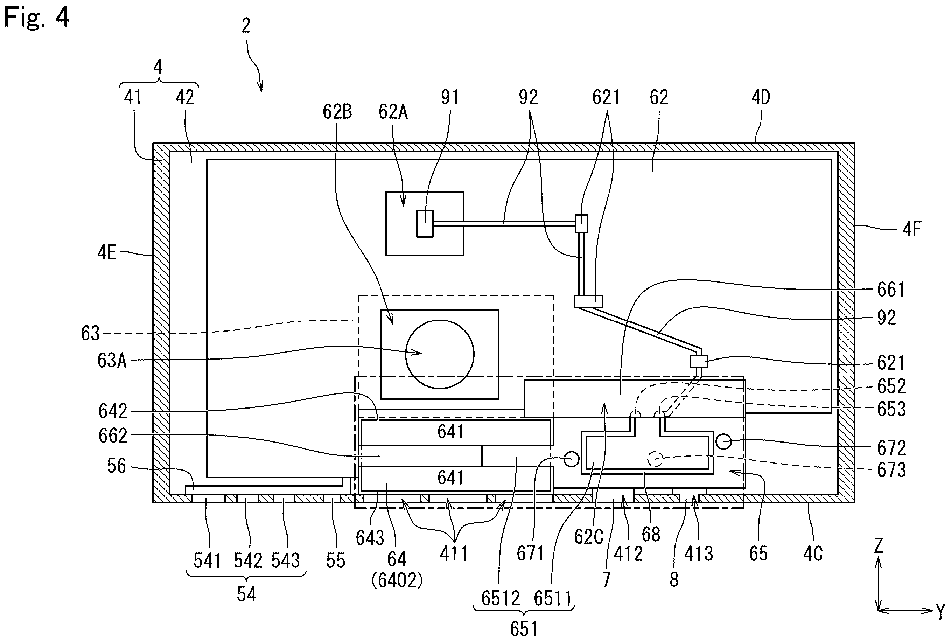

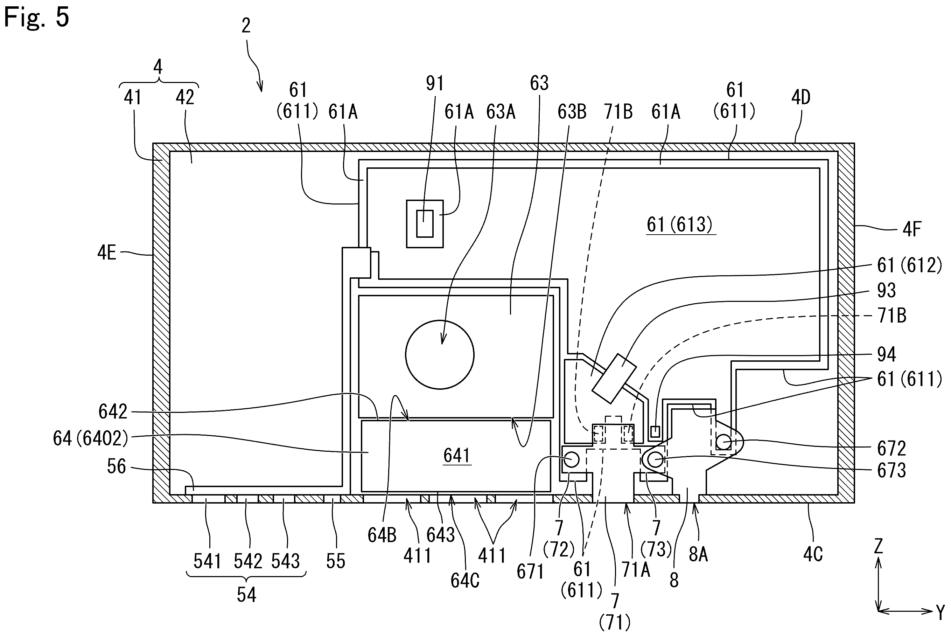

Fig. 4 is a cross-sectional view taken along line IV-IV in Fig. 3. Fig. 5 is a cross-sectional view corresponding to Fig. 4 from which an internal frame, an antenna, and a filler are removed.

The operation buttons 54 are pressed by a user to operate the electronic device 2. In the present embodiment, the operation buttons 54 include a power button 541 for turning on or off the power of the electronic device 2 and volume buttons 542 and 543 for adjusting the volume output from an audio output component such as a speaker or an earphone.

The electronic device 2 in a power-off state is activated when the power button 541 is pressed. The electronic device 2 in a power-on state is shut down when the power button 541 is pressed.

When the volume button 542 is pressed, the volume of sound output from a speaker (not shown) incorporated in the electronic device 2 is decreased. When the volume button 543 is pressed, the volume of sound output from the speaker is increased.

The operation buttons 54 and the optical sensor 55 are electrically connected to the board 61 (described later) through a flexible printed circuit board 56.

The housing 4 accommodates the board 61, an internal frame 62, a fan 63, a heat dissipator 64, an antenna 65, a connector 7, and the audio input-output component 8.

As shown in Fig. 5, the board 61 includes an insulating substrate 611 and conductive patterns. The substrate 611 includes, for example, a ceramic material or glass epoxy. The pattern includes, for example, copper. Fig. 5 shows a first ground pattern 612 and a second ground pattern 613 as the patterns. The potentials in the first ground pattern 612 and the second ground pattern 613 serve as the reference potentials for the electronic device 2. As shown in Fig. 5, the first ground pattern 612 and the second ground pattern 613 are spaced from each other. More specifically, the first ground pattern 612 and the second ground pattern 613 are out of contact with each other.

The conductive pattern includes a signal pattern and a power supply pattern (not shown), in addition to the ground patterns 612 and 613.

As shown in Fig. 5, the substrate 611 has a mount surface 61A. The mount surface 61A is perpendicular to the X-direction, which is a thickness direction of the board 61.

The first ground pattern 612 and the second ground pattern 613 may be located both outside and inside the substrate 611, or either outside or inside the substrate 611.

The second ground pattern 613 has a larger area than the first ground pattern 612. The area of the first ground pattern 612 is the total area of the first ground pattern 612 in each layer of the board 61. The area of the second ground pattern 613 is the total area of the second ground pattern 613 in each layer of the board 61.

Various electronic components are mounted on the mount surface 61A of the substrate 611. As shown in Fig. 5, for example, an antenna connector 91, a filter 93, and a spring 94 are mounted on the mount surface 61A of the substrate 611. The antenna connector 91, the filter 93, and the spring 94 will be described later.

Although not shown in Fig. 5, various electronic components such as a central processing unit (CPU) and a memory are mounted on the mount surface 61A of the substrate 611. The electronic device 2 is controlled by these various electronic components. For example, the CPU is electrically connected to the display 53 described above. The CPU thus controls displaying of images and videos on the display 53.

The internal frame 62 shown in Fig. 4 includes a metal such as aluminum. The internal frame 62 is electrically coupled to a ground pattern. In the present embodiment, the internal frame 62 is electrically coupled to the second ground pattern 613, but may be electrically coupled to the first ground pattern 612. The internal frame 62 functions as a shield to reduce noise from the components in the housing 4

(e.g., electronic components such as the CPU mounted on the board 61) or external noise affecting the components in the housing 4.

The internal frame 62 overlaps the board 61 and the fan 63 as viewed in the X-direction. In other words, the internal frame 62 faces the board 61 in the X-direction.

The internal frame 62 has a first opening 62A and a second opening 62B. The antenna connector 91 overlaps the first opening 62A as viewed in the X-direction to be electrically coupled to the antenna 65. The fan 63 has an inlet 63A aligned with the second opening 62B as viewed in the X-direction.

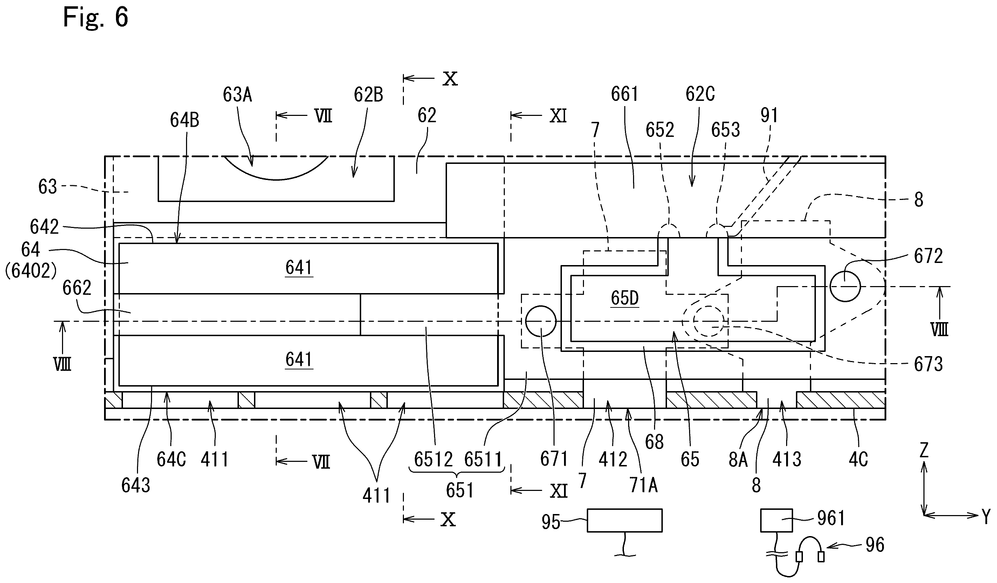

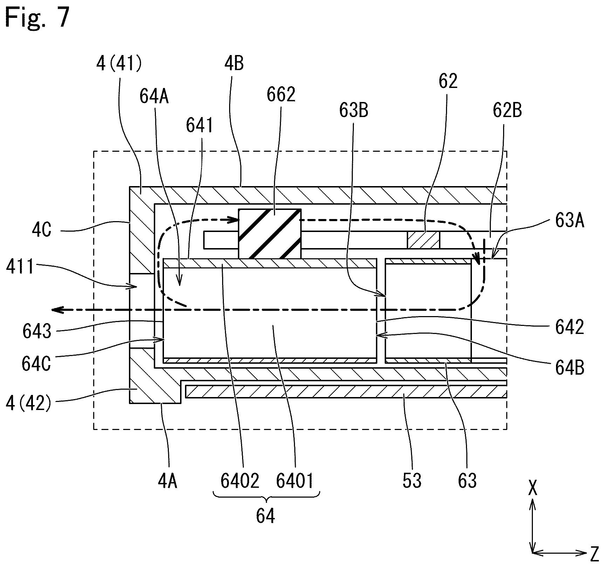

Fig. 6 is an enlarged view of a part enclosed by the dot-dash line in Fig. 4. Fig. 7 is a cross-sectional view taken along line VII-VII in Fig. 6.

The fan 63 shown in Figs. 5, 6, and 7 is driven to circulate air in the internal space of the housing 4. The fan 63 is electrically connected to the board 61 through a connector (not shown).

As shown in Figs. 5, 6, and 7, the fan 63 has the inlet 63A for drawing air and an outlet 63B for discharging air.

As shown in Fig. 7, the inlet 63A faces in the X-direction. The inlet 63A faces the first housing 41 in the X-direction through the second opening 62B in the internal frame 62.

As shown in Figs. 5 and 7, the outlet 63B faces the first side surface 4C in the Z-direction.

As shown in Figs. 4 and 6, the antenna 65 includes a base 651, a first terminal 652, and a second terminal 653. The base 651 includes an insulating material. The first terminal 652 and the second terminal 653 include a conductive material.

The base 651 includes a first portion 6511 and a second portion 6512. In the present embodiment, the first portion 6511 and the second portion 6512 are integral with each other. As shown in Fig. 6, the first portion 6511, which is a part of the antenna 65, overlaps the connector 7 as viewed in the X-direction.

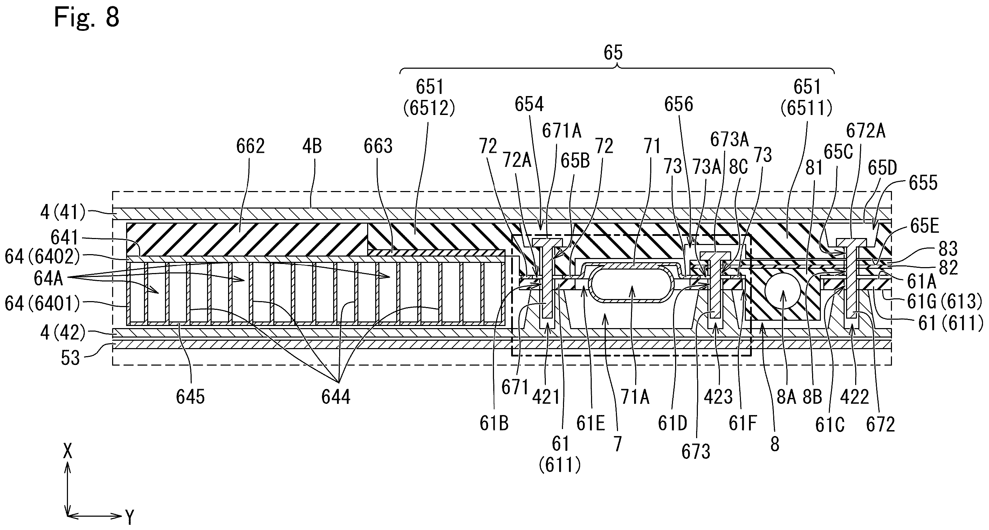

Fig. 8 is a cross-sectional view taken along line VIII-VIII in Fig. 6. As shown in Fig. 8, the first portion 6511 is located between the connector 7 and the first housing 41 and between the audio input-output component 8 and the first housing 41 in the X-direction.

The antenna 65 may fully overlap the connector 7 as viewed in the X-direction. For an antenna 65 without the second portion 6512, for example, the antenna 65 may fully overlap the connector 7 as viewed in the X-direction.

As shown in Figs. 4 and 6, the antenna 65 includes an antenna pattern 68 including a conductive material. The antenna pattern 68 is located on the surface of the first portion 6511. The antenna pattern 68 is not located in the second portion 6512. In Figs. 4 and 6, the antenna pattern 68 is located on a surface 65D (refer to Fig. 6) of the first portion 6511. The surface 65D faces a back surface 4B of the first housing 41. In some embodiments, the antenna pattern 68 may be located on a surface other than the surface 65D. In the present embodiment, for example, the antenna pattern 68 is also located on a surface 65E (refer to Fig. 8) of the first portion 6511, in addition to the surface 65D. The surface 65E faces the second housing 42. The antenna pattern 68 may be located on, for example, the surface of the first portion 6511 facing in the direction perpendicular to the X-direction (e.g., the Y-direction or the Z-direction) or the surface of the second portion 6512. The antenna pattern 68 may be located inside the antenna 65. An electronic device 2 with the antenna pattern 68 located inside the antenna 65 includes, for example, an electronic device 2 with the antenna pattern 68 covered with a resin on the surface of the antenna 65 and an electronic device 2 with the antenna pattern 68 located in an inner layer in a resin multilayer board included in the antenna 65.

The antenna pattern 68 is connected to the first terminal 652 and the second terminal 653. In the present embodiment, the first terminal 652 is connected to one end of the antenna pattern 68, and the second terminal 653 is connected to the other end of the antenna pattern 68. The first terminal 652 is electrically connected to the second ground pattern 613. The second terminal 653 is connected to the antenna connector 91 with wiring 92, which is a cable or a harness. The wiring 92 is fastened to the internal frame 62 with clips 621. The antenna connector 91 is connected to the CPU through the signal pattern.

The antenna pattern 68 may not be in the shape shown in Figs. 4 and 6. For example, the antenna pattern 68 may include multiple portions that are out of contact with one another. In this case, two portions that are out of contact with each other form a capacitor that allows alternating current to flow.

As shown in Figs. 5 and 8, the connector 7 is located between the heat dissipator 64 and the audio input-output component 8 in the Y-direction. As shown in Fig. 8, the connector 7 is located between the antenna 65 and the second housing 42 in the X-direction.

As shown in Fig. 6, the connector 7 is adjacent to the first connector opening 412 in the first side surface 4C of the first housing 41. The connector 7 is mounted on the board 61 and connected to the CPU through the signal pattern. In the present embodiment, the connector 7 is a USB Type-C connector, but may be a connector other than a USB connector.

As shown in Figs. 5 and 8, the connector 7 includes a body 71, a first flange 72, and a second flange 73.

The body 71 includes the connection terminal 71A. The connection terminal 71A is open to the outside of the electronic device 2 in the Z-direction through the first connector opening 412. As shown in Fig. 6, an external connector 95 is connected to the connection terminal 71A through the first connector opening 412. The external connector 95 is, for example, a connector in another controller different from the two controllers 51 and 52 described above.

As shown in Fig. 8, the first flange 72 extends from the body 71 toward a first position in the Y-direction (in other words, toward the heat dissipator 64). The second flange 73 extends from the body 71 toward a second position in the Y-direction (in other words, toward the audio input-output component 8).

As shown in Figs. 5 and 8, the audio input-output component 8 is adjacent to the connector 7 in the Y-direction. As shown in Fig. 8, the audio input-output component 8 is located between the antenna 65 and the second housing 42 in the X-direction.

The audio input-output component 8 has an insertion port 8A. The insertion port 8A is open to the outside of the electronic device 2 in the Z-direction through the second connector opening 413. As shown in Fig. 6, an audio terminal 961 of headphones 96 is placed into the insertion port 8A through the second connector opening 413. The surface defining the insertion port 8A includes a conductive material. In the present embodiment, the audio terminal 961 is a terminal of the headphones 96, but may be any other terminal. For example, the audio terminal 961 may be a terminal of earphones or a headset.

As shown in Fig. 6, the insertion port 8A of the audio input-output component 8 is adjacent to the second connector opening 413 in the first side surface 4C of the first housing 41.

As shown in Fig. 8, the audio input-output component 8 includes a body 81 having an outer surface including an insulating material, a flexible printed circuit board 82, and an auxiliary board 83.

As shown in Fig. 8, the flexible printed circuit board 82 is supported by the body 81. The flexible printed circuit board 82 is connected to the board 61. This allows electrical connection between the audio input-output component 8 and the CPU mounted on the board 61 through the signal pattern. In other words, the audio terminal 961 placed through the insertion port 8A is electrically connected to the CPU. The flexible printed circuit board 82 is held between the auxiliary board 83 and the body 81.

The antenna 65, the connector 7, and the audio input-output component 8 are fastened to the second housing 42 and the board 61. This will be described below.

As shown in Fig. 8, the antenna 65 has a first through-hole 65B and a second through-hole 65C extending in the X-direction through the first portion 6511 of the base 651.

The first flange 72 in the connector 7 has a third through-hole 72A extending in the X-direction through the first flange 72. The second flange 73 in the connector 7 has a fourth through-hole 73A extending in the X-direction through the second flange 73.

The audio input-output component 8 has a fifth through-hole 8B and a sixth through-hole 8C extending in the X-direction through the body 81, the flexible printed circuit board 82, and the auxiliary board 83.

The board 61 has a seventh through-hole 61B, an eighth through-hole 61C, and a ninth through-hole 61D extending in the X-direction through the substrate 611.

The second housing 42 has a first hole 421, a second hole 422, and a third hole 423. In the present embodiment, the first hole 421, the second hole 422, and the third hole 423 do not extend through the second housing 42, but may extend through the second housing 42.

The first through-hole 65B in the antenna 65, the third through-hole 72A in the connector 7, the seventh through-hole 61B in the board 61, and the first hole 421 in the second housing 42 are aligned with one another as viewed in the X-direction. These holes are arranged in the order of the first through-hole 65B, the third through-hole 72A, the seventh through-hole 61B, and the first hole 421 in the X-direction from the first housing 41 to the second housing 42.

A first fastener 671 extends through the first through-hole 65B, the third through-hole 72A, and the seventh through-hole 61B and is received in the first hole 421. In the present embodiment, the first fastener 671 is a screw, which is screwed into at least the first hole 421. This integrally fastens the antenna 65, the connector 7, the second housing 42, and the board 61. More specifically, the antenna 65 and the connector 7 are integrally fastened to the second housing 42 and the board 61. The first fastener 671 may be screwed into, for example, the seventh through-hole 61B, in addition to the first hole 421.

The second through-hole 65C in the antenna 65, the fifth through-hole 8B in the audio input-output component 8, the eighth through-hole 61C in the board 61, and the second hole 422 in the second housing 42 are aligned with one another as viewed in the X-direction. These holes are arranged in the order of the second through-hole 65C, the fifth through-hole 8B, the eighth through-hole 61C, and the second hole 422 in the X-direction from the first housing 41 to the second housing 42.

A second fastener 672 extends through the second through-hole 65C, the fifth through-hole 8B, and the eighth through-hole 61C and is received in the second hole 422. In the present embodiment, the second fastener 672 is a screw, which is screwed into at least the second hole 422. This integrally fastens the antenna 65, the audio input-output component 8, the second housing 42, and the board 61. More specifically, the antenna 65 and the audio input-output component 8 are integrally fastened to the second housing 42 and the board 61. The second fastener 672 may be screwed into, for example, the eighth through-hole 61C, in addition to the second hole 422.

The sixth through-hole 8C in the audio input-output component 8, the fourth through-hole 73A in the connector 7, the ninth through-hole 61D in the board 61, and the third hole 423 in the second housing 42 are aligned with one another as viewed in the X-direction. These holes are arranged in the order of the sixth through-hole 8C, the fourth through-hole 73A, the ninth through-hole 61D, and the third hole 423 in the X-direction from the first housing 41 to the second housing 42.

A third fastener 673 extends through the sixth through-hole 8C, the fourth through-hole 73A, and the ninth through-hole 61D and is received in the third hole 423.

In the present embodiment, as shown in Fig. 6, the third fastener 673 overlaps the antenna 65 as viewed in the X-direction. The third fastener 673 is located inward from the antenna pattern 68 (in other words, in the space defined by the antenna pattern 68 that is substantially a loop) as viewed in the X-direction. The third fastener 673 may overlap the antenna pattern 68 as viewed in the X-direction.

In the present embodiment, the third fastener 673 is a screw, which is screwed into at least the third hole 423. This integrally fastens the connector 7, the audio input-output component 8, the second housing 42, and the board 61. More specifically, the connector 7 and the audio input-output component 8 are integrally fastened to the second housing 42 and the board 61. The third fastener 673 may be screwed into, for example, the ninth through-hole 61D, in addition to the third hole 423.

In the present embodiment, as shown in Fig. 8, the antenna 65 has recesses 654, 655, and 656 respectively corresponding to a thread head 671A of the first fastener 671, a thread head 672A of the second fastener 672, and a thread head 673A of the third fastener 673. The electronic device 2 may not have a dimension increased for accommodating the screw heads. The electronic device 2 allows the antenna 65 to overlap the connector 7 and the audio input-output component 8 and to be fastened with the fasteners 671, 672, and 673. This achieves the electronic device 2 being thinner.

The connection terminal 71A of the connector 7 is located between the first fastener 671 and the third fastener 673 in the Y-direction. The insertion port 8A of the audio input-output component 8 is located between the second fastener 672 and the third fastener 673 in the Y-direction. The connection terminal 71A and the insertion port 8A are located between the first fastener 671 and the second fastener 672 in the Y-direction. More specifically, the third fastener 673 is located between the first fastener 671 and the second fastener 672 in the present embodiment. The third fastener 673 may not be located between the first fastener 671 and the second fastener 672.

In Fig. 8, a clearance is left between each fastener and the corresponding holes. Each fastener refers to the first fastener 671, the second fastener 672, or the third fastener 673. Each of the corresponding holes refers to the hole 65B, 65C, 61B, 61C, 61D, 421, 422, 423, 8B, or 8C. However, the fasteners are connected directly or indirectly to the holes. Being connected directly refers to being in contact with each other. Being connected indirectly refers to, for example, being connected to each other through a conductive film of, for example, copper on the side surface of each hole. As described later, each fastener is out of contact with the corresponding through-hole 72A or 73A in the connector 7.

The antenna 65, the connector 7, and the audio input-output component 8 are fastened to the second housing 42, but may be fastened to the first housing 41.

The antenna 65, the connector 7, and the audio input-output component 8 are fastened to both the second housing 42 and the board 61, but may be fastened to either the second housing 42 or the board 61.

The first fastener 671, the second fastener 672, and the third fastener 673 include a metal.

The first fastener 671, the second fastener 672, and the third fastener 673 are not limited to screws. The first fastener 671, the second fastener 672, and the third fastener 673 may be any fasteners that integrally fasten the antenna 65, the connector 7, and the audio input-output component 8 to at least one of the housing 4 or the board 61. For example, the first fastener 671, the second fastener 672, and the third fastener 673 may be bolts and nuts. For example, the first fastener 671, the second fastener 672, and the third fastener 673 may be pins. In this case, each pin may be fixed to, for example, the antenna 65, the connector 7, the board 61, and the audio input-output component 8 with an adhesive.

As shown in Fig. 6, the second portion 6512 of the base 651 in the antenna 65 overlaps the heat dissipator 64 as viewed in the X-direction. As shown in Fig. 8, the second portion 6512 is located between the heat dissipator 64 and the first housing 41 in the X-direction.

As shown in Figs. 4, 5, and 8, the heat dissipator 64 is adjacent to the connector 7 in the Y-direction. As shown in Figs. 4 and 5, the heat dissipator 64 is located between the connector 7 and the optical sensor 55 in the Y-direction.

As shown in Figs. 4, 5, and 7, the heat dissipator 64 is located between the fan 63 and the air vents 411 in the Z-direction.

The heat dissipator 64 includes a metal with high thermal conductivity, such as aluminum or copper. In the present embodiment, the heat dissipator 64 includes a fin 6401 and a heat sink 6402 supported by the fin 6401. Although the fin 6401 and the heat sink 6402 are separate components in the present embodiment, the fin 6401 and the heat sink 6402 may be integral with each other. The heat dissipator 64 may not include the heat sink 6402.

As shown in Fig. 8, the fin 6401 includes a bottom plate 645 and multiple inner walls 644 extending in the X-direction from the bottom plate 645. The inner walls 644 are arranged in the Y-direction and extend in the X- and Z-directions. The fin 6401 is thus open at both ends in the Z-direction and is open at one end in the X-direction. The heat sink 6402 is supported by the inner walls 644 of the fin 6401. The heat sink 6402 thus covers the open end of the fin 6401 in the X-direction.

As shown in Figs. 5, 7, and 8, the heat dissipator 64 is a generally rectangular prism and has a facing surface 641, a first side surface 642, and a second side surface 643. The facing surface 641 is on the heat sink 6402, and the first side surface 642 and the second side surface 643 are on the fin 6401. The heat dissipator 64 may not be a rectangular prism.

As shown in Fig. 5, the facing surface 641 extends in the Y- and Z-directions. As shown in Figs. 7 and 8, the facing surface 641 faces the surface of the first housing 41 opposite to the back surface 4B in the X-direction.

As shown in Fig. 7, the first side surface 642 and the second side surface 643 extend in the X-direction from the facing surface 641 toward the second housing 42 and the display 53. The first side surface 642 faces the fan 63 in the Z-direction. The second side surface 643 faces the air vents 411 in the Z-direction.

As shown in Fig. 8, the heat dissipator 64 includes multiple (ten in Fig. 8) flow paths 64A as internal spaces. Two inner walls 644 adjacent to each other separate each of the multiple flow paths 64A. The heat dissipator 64 may include any number of flow paths 64A other than shown in Fig. 8. The fin 6401 may not be separated by the inner walls 644 extending in the X- and Z-directions, unlike as shown in Fig. 8. For example, rod-like members extending in the X-direction may be arranged in the Y- and Z-directions, in place of the inner walls 644. The fin 6401 may include, for example, a single bellows-like inner wall.

As shown in Fig. 7, the flow paths 64A extend in the Z-direction and are open to the outside of the heat dissipator 64 through first clearances 64B and second clearances 64C. More specifically, the same number of first clearances 64B as the flow paths 64A are arranged, and the same number of second clearances 64C as the flow paths 64A are arranged. The first clearances 64B are defined with the first side surface 642. The second clearances 64C are defined with the second side surface 643.

The first clearances 64B face the outlet 63B of the fan 63 in the Z-direction. The second clearances 64C face the air vents 411 in the Z-direction.

As shown in Figs. 6, 7, and 8, a portion of the antenna 65 and a blocking member 662 are located in the clearance between the facing surface 641 of the heat dissipator 64 and the surface of the first housing 41 opposite to the back surface 4B. The portion of the antenna 65 is the second portion 6512 of the base 651. The blocking member 662 is formed from, for example, a sponge material (urethane foam). The second portion 6512 and the blocking member 662 are aligned in the Y-direction. The second portion 6512 and the blocking member 662 are located in a portion of the facing surface 641 (specifically, in the middle of the facing surface 641 in the Z-direction).

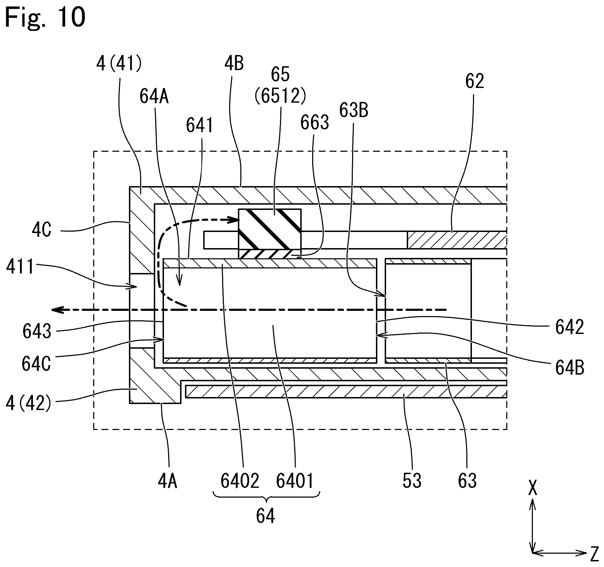

As shown in Fig. 7, the blocking member 662 is supported on the facing surface 641. Fig. 10 is a cross-sectional view taken along line X-X in Fig. 6. As shown in Figs. 8 and 10, the second portion 6512 of the antenna 65 is supported on the facing surface 641 with a support 663 between them. The support 663 is formed from, for example, a sponge material (urethane foam). The blocking member 662, the second portion 6512 of the antenna 65, and the support 663 thus fill the clearance between the heat dissipator 64 and the first housing 41 and reduce the likelihood of the heat sink 6402 being separated (in other words, the heat sink 6402 moving away from the fin 6401 toward the first housing 41).

As indicated by the dot-and-dash arrows in Figs. 7 and 10, air drawn into the fan 63 through the inlet 63A of the fan 63 is discharged out of the fan 63 through the outlet 63B of the fan 63. Air warmed by, for example, the CPU in the internal space of the housing 4 is drawn in and discharged from the fan 63. The air discharged from the fan 63 passes through the heat dissipator 64. More specifically, the air discharged from the fan 63 enters the flow paths 64A inside the heat dissipator 64 through the first clearances 64B, passes through the flow paths 64A, and is discharged out of the heat dissipator 64 through the second clearances 64C. The air is cooled while passing through the heat dissipator 64. Most of the air discharged out of the heat dissipator 64 through the second clearances 64C is discharged out of the housing 4 through the air vents 411.

The fin 6401 is open at one end in the X-direction. This may cause air in the flow paths 64A to flow toward the first housing 41 through the open end of the fin 6401. In the present embodiment, however, the open end is covered with the heat sink 6402, reducing air flowing toward the first housing 41 through the open end.

As indicated by the two-dot-dash arrows in Figs. 7 and 10, part of air discharged out of the heat dissipator 64 through the second clearances 64C may flow into the clearance between the heat dissipator 64 and the first housing 41. The second portion 6512 and the blocking member 662 located in the clearance reduce air flowing into the clearance. This reduces the likelihood that air flowing through the clearance is redrawn by the fan 63 as indicated by the broken arrows in Figs. 7 and 10.

More specifically, the second portion 6512 and the blocking member 662 block the flow channel extending from the second clearances 64C in the heat dissipator 64 to the inlet 63A of the fan 63 through the clearance between the facing surface 641 and the first housing 41. In Fig. 7, the flow channel is a space extending along the two-dot-dash arrow and the broken arrow to the inlet 63A.

In the present embodiment, the first housing 41 and the second portion 6512 are spaced from each other in the X-direction, and the first housing 41 and the blocking member 662 are spaced from each other in the X-direction. More specifically, the second portion 6512 and the blocking member 662 partially block the flow channel. However, the first housing 41 and the second portion 6512 may be in contact with each other in the X-direction, and the first housing 41 and the blocking member 662 may be in contact with each other in the X-direction. In this case, the second portion 6512 and the blocking member 662 fully block the flow channel. In other words, the second portion 6512 and the blocking member 662 at least partially block the flow channel.

In the present embodiment, the second portion 6512 and the blocking member 662 are located in the middle of the facing surface 641 in the Z-direction. In some embodiments, the second portion 6512 and the blocking member 662 may be located at, for example, the end of the facing surface 641 adjacent to the fan 63 in the Z-direction, rather than in the middle.

In the present embodiment, the second portion 6512 and the blocking member 662 are located on a part of the facing surface 641, but may be located on the entire area of the facing surface 641.

In the present embodiment, the second portion 6512, which is a portion of the antenna 65, and the blocking member 662 are located in the clearance between the facing surface 641 and the first housing 41. Both the second portion 6512 and the blocking member 662 block the clearance. However, either the second portion 6512 or the blocking member 662 alone may block the clearance. For example, the second portion 6512 may block a portion of the clearance in which the blocking member 662 is located as shown in Fig. 6. In some embodiments, the blocking member 662 may block a portion of the clearance in which the second portion 6512 is located as shown in Fig. 6.

As shown in Figs. 4 and 6, the first portion 6511 of the antenna 65 is aligned in the Z-direction with respect to a part of the internal frame 62 as viewed in the X-direction. The internal frame 62 has a cutout 62C in a portion adjacent to the first portion 6511 in the Z-direction. The cutout 62C is cut from the edge of the internal frame 62 in a direction opposite to the first portion 6511 in the Z-direction as viewed in the X-direction. The cutout 62C is a clearance between the first portion 6511 and the internal frame 62 as viewed in the X-direction. The cutout 62C allows the internal frame 62 to be away from the antenna 65. This reduces the likelihood that the internal frame 62 affects the radiation characteristics of the antenna 65. Examples of the effect on the radiation characteristics of the antenna 65 caused by the internal frame 62 include coupling of the antenna 65 and the internal frame 62 through the magnetic field or the electric field.

The cutout 62C receives a filler 661. The filler 661 extends across the entire area of the cutout 62C as viewed in the X-direction. More specifically, the filler 661 fills the cutout 65C, which is a clearance between the first portion 6511 and the internal frame 62. The filler 661 is formed from, for example, a sponge material (urethane foam). The filler 661 is formed from an insulating material.

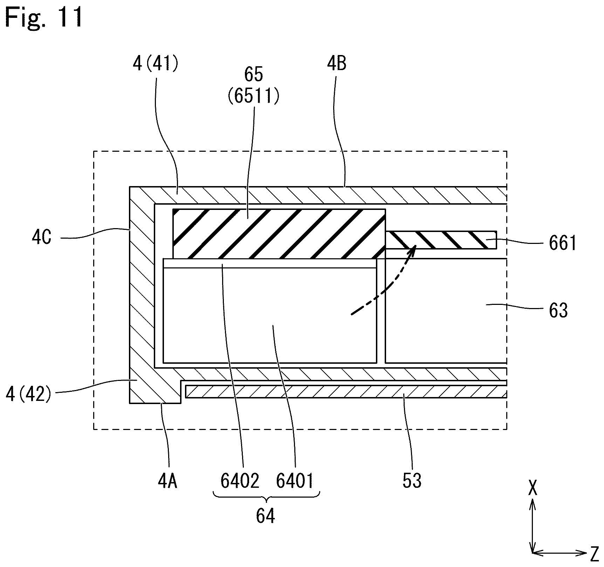

Fig. 11 is a cross-sectional view taken along line XI-XI in Fig. 6. As indicated by the broken arrow in Fig. 11, heat generated in a heat-generating component such as an integrated circuit mounted on the board 61 can spread in the housing 4 through the cutout 62C. In the present embodiment, however, the cutout 62C is filled with the insulating filler 661. The filler 661 thus reduces heat dissipation from the heat-generating component through the cutout 62C.

The electrical connection of the filter 93, the antenna 65, the connector 7, and the audio input-output component 8 to the first ground pattern 612 and the second ground pattern 613 will be described below.

In the structure according to one or more embodiments of the present disclosure, the second ground pattern 613 is connected to a system on a chip (SoC) mounted on the board 61 or to the antenna 65. Without the filter 93, noise may be transmitted from the second ground pattern 613 to the first ground pattern 612, and the first ground pattern 612 may deviate from the reference potential. The connector 7 according to one or more embodiments of the present disclosure may also be used for data transmission and reception in a high frequency range. The connector 7 is thus susceptible to ground noise. The first ground pattern 612 electrically connected to the connector 7 and the second ground pattern 613 are thus connected to each other through the filter 93. This reduces noise propagating from the second ground pattern 613 to the first ground pattern 612. This allows the first ground pattern 612 to be a ground with less noise (or in other words, closer to the reference potential), and reduces the likelihood that noise affects the connector 7.

As shown in Fig. 5, the first ground pattern 612 and the second ground pattern 613 are spaced from each other as described above. The filter 93 is mounted on the mount surface 61A of the substrate 611 to extend across the first ground pattern 612 and the second ground pattern 613. The filter 93 is electrically connected to both the first ground pattern 612 and the second ground pattern 613. In other words, the first ground pattern 612 is electrically connected to the second ground pattern 613 through the filter 93.

As described in detail below, the antenna 65 and the audio input-output component 8 are electrically connected to the second ground pattern 613, and the connector 7 is electrically connected to the first ground pattern 612. A current flowing through the connector 7 has a lower frequency band than a current flowing through the antenna 65 (specifically, the antenna pattern 68 of the antenna 65).

The second ground pattern 613 is also located on the back mount surface 61G (refer to Fig. 8), in addition to the mount surface 61A of the substrate 611. In Fig. 8, the second ground pattern 613 is not shown. The second ground pattern 613 on the mount surface 61A and the second ground pattern 613 on the back mount surface 61G are electrically connected to each other through a through-hole (not shown) extending in the X-direction through the substrate 611.

The second housing 42 including a metal is in contact with the second ground pattern 613 on the back mount surface 61G. The second housing 42 is thus electrically connected to the second ground pattern 613.

The audio input-output component 8 may be electrically connected to the second ground pattern 613 on the mount surface 61A through the flexible printed circuit board 82.

The antenna pattern 68 of the antenna 65 is electrically connected to the second ground pattern 613 through the first terminal 652.

As shown in Fig. 5, the spring 94 is mounted on the mount surface 61A of the board 61. The spring 94 includes a metal and is in contact with the second ground pattern 613 on the mount surface 61A. The spring 94 is in contact with the antenna pattern 68 on the surface 65E of the first portion 6511. As described above, the antenna pattern 68 on the surface 65E of the first portion 6511 is electrically connected to the second ground pattern 613 on the mount surface 61A through the spring 94.

As shown in Fig. 5, the body 71 of the connector 7 includes ground terminals 71B. The ground terminals 71B are arranged on the surface of the body 71 facing the first ground pattern 612 in the X-direction. The ground terminals 71B are connected to the first ground pattern 612. The connector 7 is thus electrically connected to the first ground pattern 612 through the ground terminals 71B. The body 71 of the connector 7 includes a signal terminal (not shown) in addition to the ground terminals 71B. The signal terminal is connected to the signal pattern on the board 61.

As described in detail later, the first flange 72 and the second flange 73 on the connector 7 are out of contact with the second ground pattern 613.

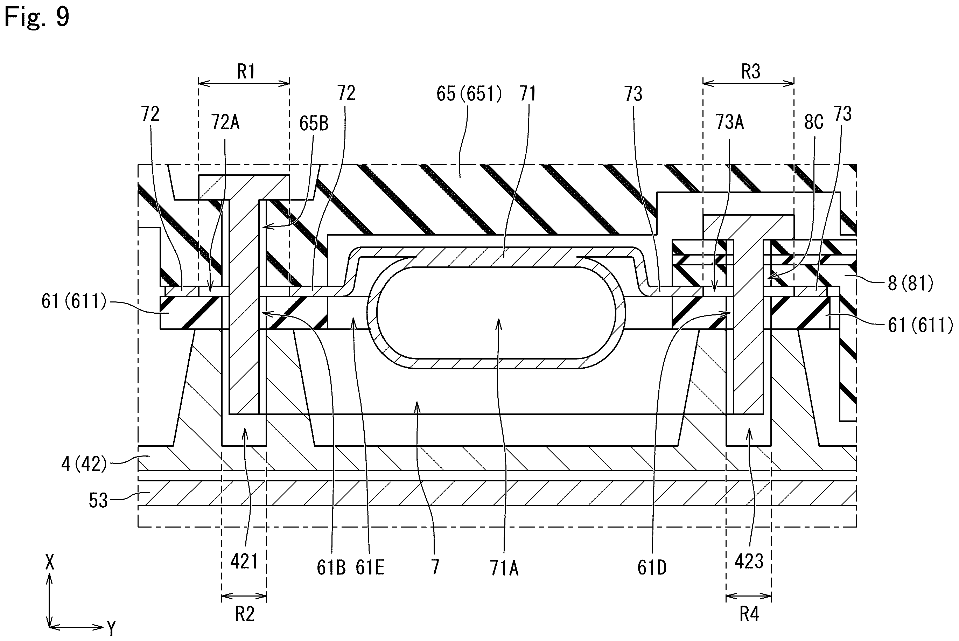

Fig. 9 is an enlarged view of a portion enclosed by the dot-dash line in Fig. 8. As shown in Figs. 8 and 9, the first flange 72 is held between the base 651 in the antenna 65 and the substrate 611 in the board 61. The first flange 72 is in contact with both the base 651 and the substrate 611.

The first flange 72 is out of contact with the first fastener 671. Although the first flange 72 is in contact with the mount surface 61A of the substrate 611, the second ground pattern 613 is not at a contact position between the first flange 72 and the mount surface 61A. More specifically, the first flange 72 is out of contact with the second ground pattern 613. The first flange 72 is in contact with the base 651 of the antenna 65, but is out of contact with the antenna pattern 68 of the antenna 65.

As shown in Fig. 9, the third through-hole 72A in the first flange 72 has a diameter R1 larger than a diameter R2 of the first through-hole 65B in the antenna 65 and the seventh through-hole 61B in the board 61. This reduces, for example, contact between the first flange 72 and a conductive material on the side surface defining the seventh through-hole 61B in the board 61 when the conductive material such as copper overflows from the seventh through-hole 61B onto the mount surface 61A of the board 61. This reduces the likelihood that the first flange 72 is electrically connected to the second ground pattern 613 on the back mount surface 61G or the second housing 42 through the conductive material and the first fastener 671. Similarly, a conductive material on the first through-hole 65B in the antenna 65 can reduce the likelihood that the conductive material comes in contact with the first flange 72.

As shown in Figs. 8 and 9, the second flange 73 is held between the body 81 in the audio input-output component 8 and the substrate 611 in the board 61. The second flange 73 is in contact with both the body 81 and the substrate 611.

The second flange 73 is out of contact with the third fastener 673. Although the second flange 73 is in contact with the mount surface 61A of the substrate 611, the second ground pattern 613 is not at a contact position between the second flange 73 and the mount surface 61A. In other words, the second flange 73 is out of contact with the second ground pattern 613.

As shown in Fig. 9, the fourth through-hole 73A in the second flange 73 has a diameter R3 larger than a diameter R4 of the sixth through-hole 8C in the audio input-output component 8 and the ninth through-hole 61D in the board 61. This reduces, for example, contact between the second flange 73 and a conductive material on the side surface defining the ninth through-hole 61D in the board 61 when the conductive material such as copper overflows from the ninth through-hole 61D onto the mount surface 61A of the board 61. This reduces the likelihood that the second flange 73 is electrically connected to the second ground pattern 613 on the back mount surface 61G or the second housing 42 through the conductive material and the third fastener 673. Similarly, a conductive material on the sixth through-hole 8C in the audio input-output component 8 can reduce the likelihood that the conductive material comes in contact with the second flange 73.

The connector 7 is thus fastened to the second housing 42 with the insulating substrate 611 between them to prevent electrical connection to the second housing 42. More specifically, the connector 7 is fastened indirectly to the second housing 42 to prevent electrical connection to the second housing 42.

The connector 7 is fastened to the second housing 42 with the substrate 611 between them while being out of contact with the second ground pattern 613.

The connector 7 is held between the base 651 and the substrate 611 while being in contact with both the base 651 and the substrate 611 but out of contact with the antenna pattern 68 and the second ground pattern 613.

The embodiments and modifications described above may be combined with one another to produce their advantageous effects.

### EXPLANATION OF REFERENCES

- 2: electronic device
- 4: housing
- 42: second housing (metal frame)
- 61: board
- 61A: mount surface
- 611: substrate
- 612: first ground pattern
- 613: second ground pattern
- 62: internal frame
- 62C: cutout (clearance)
- 63: fan
- 63A: inlet
- 63B: outlet
- 64: heat dissipator
- 64A: flow path (internal space)
- 64B: first clearance
- 64C: second clearance
- 641: facing surface
- 642: first side surface
- 643: second side surface
- 65: antenna
- 68: antenna pattern
- 651: base
- 6511: first portion
- 6512: second portion
- 661: filler
- 671: first fastener
- 672: second fastener
- 673: third fastener
- 7: connector
- 71A: connection terminal
- 8: audio input-output component
- 8A: insertion port
- 93: filter
- 95: external connector
- 961: audio terminal

## Claims

1. An electronic device, comprising:
a housing;
a board in the housing;
a connector mounted on a mount surface of the board, the connector being connectable to an external connector; and
an antenna at least partially overlapping the connector as viewed in a thickness direction of the board perpendicular to the mount surface of the board, the antenna including an antenna pattern being conductive,
wherein the antenna and the connector are integrally fastened to at least one of the housing or the board.

2. The electronic device according to claim 1, further comprising:
a heat dissipator including a metal, the heat dissipator being adjacent to the connector in the housing; and
a fan having an inlet and an outlet,
wherein the heat dissipator includes
an internal space being open outside through a first clearance and a second clearance,
a facing surface facing the housing in the thickness direction,
a first side surface extending in the thickness direction from the facing surface and having the first clearance, and
a second side surface extending in the thickness direction from the facing surface and having the second clearance,
the inlet of the fan faces the housing in the thickness direction,
the outlet of the fan faces the first clearance of the heat dissipator, and
the antenna includes
a first portion overlapping the connector as viewed in the thickness direction, and
a second portion located in a clearance between the facing surface of the heat dissipator and the housing, the second portion at least partially blocking a flow channel extending from the second clearance of the heat dissipator to the inlet of the fan through the clearance between the facing surface of the heat dissipator and the housing.

3. The electronic device according to claim 2, wherein
the antenna pattern is located in the first portion and is not located in the second portion.

4. The electronic device according to claim 2, further comprising:
an internal frame in the housing, the internal frame including a metal and facing the board in the thickness direction; and
a filler being insulating and filling a clearance between the antenna and the internal frame as viewed in the thickness direction.

5. The electronic device according to any one of claims 1 to 4, further comprising:
an audio input-output component adjacent to the connector in the housing, the audio input-output component being configured to receive an audio terminal,
wherein the audio input-output component and the connector are integrally fastened to at least one of the housing or the board.

6. The electronic device according to claim 5, further comprising:
a first fastener integrally fastening the antenna and the connector to at least one of the housing or the board; and
a second fastener integrally fastening the antenna and the audio input-output component to at least one of the housing or the board.

7. The electronic device according to claim 6, wherein
the connector includes a connection terminal configured to be connected to an external connector,
the audio input-output component includes an insertion port to receive an audio terminal, and
the connection terminal and the insertion port are located between the first fastener and the second fastener.

8. The electronic device according to claim 6, further comprising:
a third fastener between the first fastener and the second fastener, the third fastener integrally fastening the connector and the audio input-output component to at least one of the housing or the board.

9. The electronic device according to any one of claims 1 to 4, further comprising:
a filter mounted on the board,
wherein the board includes
a first ground pattern electrically connected to the connector, and
a second ground pattern electrically connected to the first ground pattern through the filter and electrically connected to the antenna.

10. The electronic device according to claim 9, wherein
the second ground pattern has a larger area than the first ground pattern.

11. The electronic device according to claim 9, wherein
a current flowing through the connector has a lower frequency band than a current flowing through the antenna.

12. The electronic device according to claim 9, wherein
the housing includes a metal frame,
the second ground pattern is electrically connected to the metal frame, and
the connector is fastened to the metal frame indirectly to prevent electrical connection to the metal frame.

13. The electronic device according to claim 12, wherein
the board includes
a substrate being insulating, and
the first ground pattern and the second ground pattern located on a surface of the substrate or inside the substrate, or on the surface of the substrate and inside the substrate, and
the connector is fastened to the metal frame with the substrate being between the connector and the metal frame, and the connector is out of contact with the second ground pattern.

14. The electronic device according to claim 13, wherein
the antenna includes
a base being insulating, and
the antenna pattern on a surface of the base, and
the connector is held between the base and the substrate, and the connector is in contact with the base and the substrate and is out of contact with the antenna pattern and the second ground pattern.
